# EUROPÄISCHE PATENTSCHRIFT

(11) **EP 0 900 858 B1**
(45) Veröffentlichungstag und Bekanntmachung des Hinweises auf die Patenterteilung: **23.01.2002**
(21) Anmeldenummer: 98114772.1
(22) Anmeldetag: 06.08.1998
(51) Int. Cl.: C23C 14/24, C23C 14/26

(54) **Keramische Flash-Verdampfer**
Ceramic flash evaporator
Evaporateur céramique à évaporation instantanée

(30) Priorität: 18.08.1997 DE 19735814
(43) Veröffentlichungstag der Anmeldung: 10.03.1999
(73) Patentinhaber: Wacker-Chemie GmbH, 81737 München (DE)
(72) Erfinder: Seifert, Martin, 87437 Kempten (DE)
(74) Vertreter: Potten, Holger

(56) Entgegenhaltungen:
- DE-A- 2 647 011
- DE-B- 1 207 179
- GB-A- 2 187 477
- US-A- 5 395 180
- PATENT ABSTRACTS OF JAPAN vol. 007, no. 053 (C-154), 3. März 1983 & JP 57 200560 A (FUJI DENKI SEIZO KK), 8. Dezember 1982

## Beschreibung

Die Erfindung betrifft keramische "Flash-TV-Verdampfer" im Folgenden auch als 'Flasher' bezeichnet.

Flasher werden zum Bedampfen von Schwarz/Weiß- bzw. Farbbildröhren mit Aluminium verwendet, um eine elektrisch leitende Schicht von einigen 100 nm in den Bildröhren zu erzeugen. Diese Schicht stellt die Elektrode zur Beschleunigung der Elektronen in der fertigen Bildröhre dar.

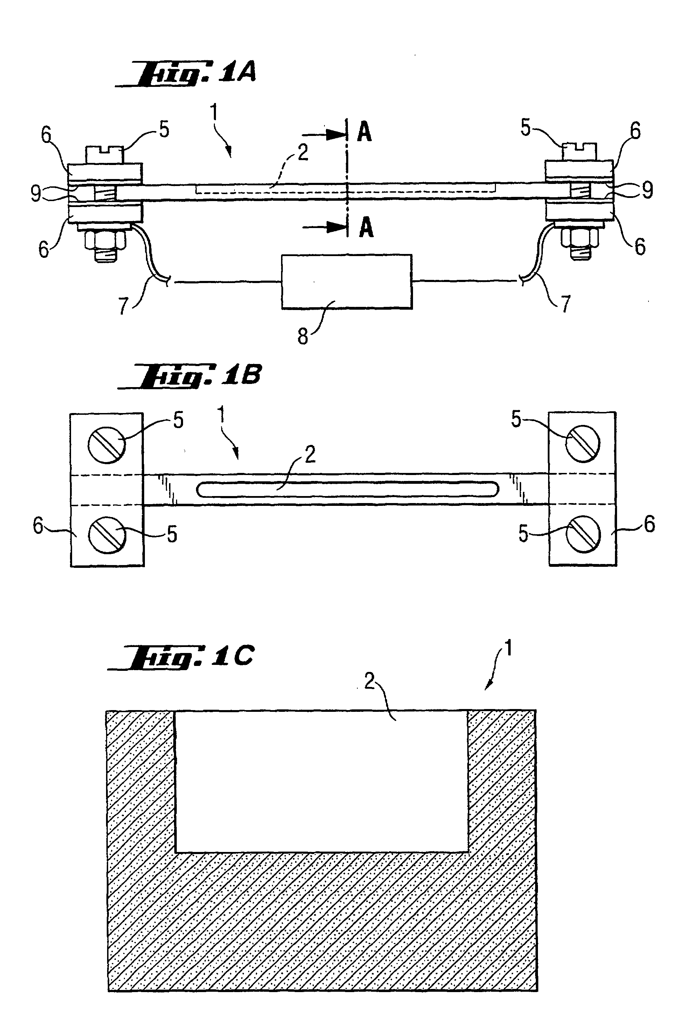

Die Maße der Flasher betragen in der Regel 4 * 6 * 110 mm. Der Flasher 1 besitzt eine im Querschnitt des Flashers rechteckige Kavität 2 (siehe Fig. 1c). Die Kavität hat in der Regel eine Dimension von 2 * 4 * 40 oder 60 mm. In der Bedampfungsanlage ist der Flasher mit Hilfe von zwei Schrauben 5 zwischen zwei Stahlplatten 6 geklemmt. Die Stahlplatten sind über Kupferkabel 7 mit einer Stromquelle 8 verbunden. Zur besseren Kontaktierung liegt in der Regel zwischen Stahlplatte 6 und Flasher 1 eine Graphitfolie 9 (siehe Fig. 1a). Die Breite der seitlichen Einspannung beträgt an beiden Enden etwa 15 mm. Die aufzuheizende Länge des Flashers beträgt normalerweise 80 mm.

Das Bedampfen der Bildröhren erfolgt wie folgt: In die Kavität des Flashers, wird ein Stück Aluminium (< 100 mg), in der Regel ein zylinderförmige Al-Körper, ein sogenanntes Pellet, gelegt. Über dem Flasher wird der zu bedampfende Bildröhrendeckel positioniert. Anschließend wird der Raum unterhalb des Bildröhrendeckels evakuiert, so daß der Flasher mit Einspannung in diesem Vakuum liegt (10⁻⁵ mbar).

Durch direkten Stromdurchgang wird der Flasher erhitzt und verdampft das in seiner Kavität liegende Aluminium. Die Zeit, die für diesen Vorgang benötigt wird, liegt im Bereich von 40 sek bis zu 2 min. Die Stromdichten, die dabei auftreten, erreichen kurzzeitig Werte bis zu 10³ A/cm².

Diese hohe Strom- und damit Temperaturbelastung ist es, die die Standzeit, d.h. die Anzahl der Aufheizzyklen des Flashers begrenzt.

Üblicherweise reißt nach 500 - 900 Aufheizzyklen der Flasher im Bereich der Kavität. Er zerbricht und muß ausgetauscht werden.

US-A-5,395,180 offenbart gemäß den Figuren einen Verdamphungstiegel, für z. B. Al, von im wesentlichen rechteckiger Form mit einer länglichen Kavität, welche als lateralen Querschnitt einen Halbkreis und/oder einen Halbkreis mit Abrundungen oder Geraden mit einem Winkel α (mit einem Wert von bevorzugt mehr als 120°C, insbesondere 135°, so daß der zwischen der Oberkante und der Geraden der Kavität eingeschlossene Winkel kleiner 60° sein muß, insbeaondere 45°) gegenüber der Verdampferoberkante aufweist (vgl. Figuren 1-6; Spalte 2, Zeile 32 bis Spalte 3, Zeile 24; Ansprüche 1-7), wobei der beschriebene Verdampfer aus Graphit und einer pyrolytischen Bornitridbeschichtung besteht. Der Verdampfer bestent aus einem Graphitkörper, der eine Beschichtung aus pyrolitischem Bornitrid als el. beheizbaren Widerstand nutzt.

DE-A 26 47 011 offenbart ein Verdampfungsschiffchen aus Metallblech für direkten Stromdurchgang, bei dem das Unterblech eine V-Form und entsprechender Kavität aufweist, die nach unten konvex ist, oder einen halbkreisartigen Boden mit entsprechender Kavität aufweist. Das Verdampferschiffchen ist nicht aus keramischen Material.

GB-A-2187477 offenbart einen konventionellen keramischen Verdampfer mit einer konventionellen rechteckigen Kavität.

Aufgabe der Erfindung ist es, keramische Flash-TV-Verdampfer zum Bedampfen von Bildröhren mit Aluminium zur Verfügung zu stellen, deren Standzeit verlängert ist, deren Verdampfungsverhalten für Aluminium definierter ist, die ein verbessertes Benetzungsverhalten zeigen und die dennoch in den üblichen Verdampferanlagen verwendet werden können.

Die vorliegende Erfindung betrifft keramische Flash-TV-Verdampfer (bestehend aus keramischen Pulvern, die TᵢB₂, BN und ggf. AlN enthalten), zum Bedampfen von Bildröhren mit Aluminium mit einer Kavität, aus der das Aluminium bei Stromdurchfluß durch den Flash-TV-Verdampfer verdampft wird, dadurch gekennzeichnet, daß sich die Breite der Kavität von der Verdampferoberkante zur Verdampferunterkante verjüngt, wobei die Kavität im Querschnitt durch den Flash-TV-Verdampfer eine Dreiecksform mit geraden Wänden, oder mit konkav gekrümmten Wänden hat.

Die erfindungsgemäßen Flasher besitzen eine Kavität, die im Querschnitt durch den Flasher, wie er in Fig. 1 für einen herkömmlichen Flasher mit Querschnitt A - A wiedergegeben ist, eine Dreiecksform zeigen, wobei die beiden Seitenflächen des Dreiecks, die dem Verdampfer zugewandt sind, gerade (Fig. 2) oder konkav (Fig. 3)gekrümmt sein können. Der tiefste Punkt der Kavität kann als Radius ausgebildet sein (Fig. 4).

Im Extremfall führt dies bei einer konkaven Krümmung der Seitenflächen zu einer schmalen linienförmigen Vertiefung in Längsrichtung des Flashers als Kavität.

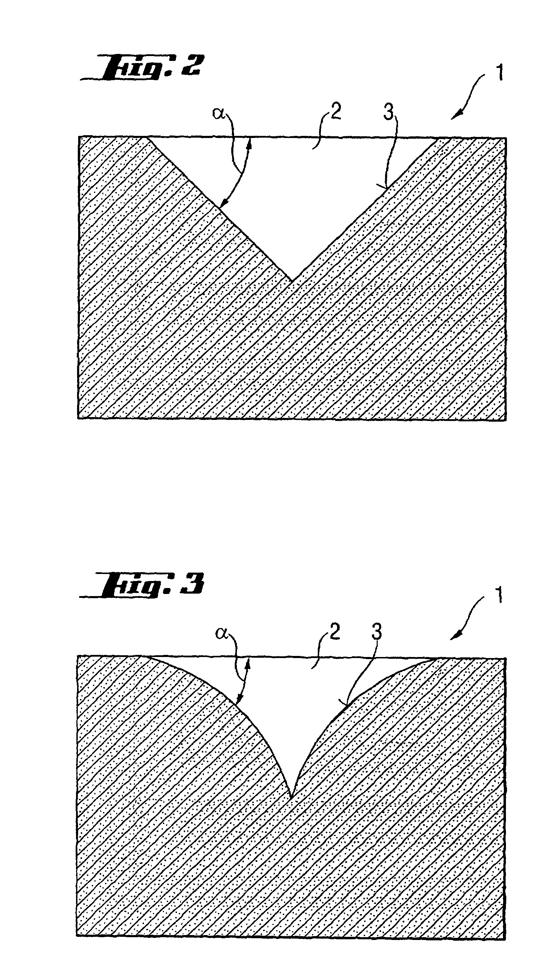

Vorzugsweise liegt der Winkel Alpha gemäß Fig. 2 - 4 zwischen 25° und 60°.

Vorzugsweise ist die Kavität an der Verdampferoberfläche 2 mm bis 6 mm breit.

Vorzugsweise liegt die tiefste Stelle der Kavität mindestens 1 mm und maximal 3 mm über der Verdampferunterkante.

Vorzugsweise beträgt die Länge der Kavität zwischen 30 mm und 80 mm.

Durch die erfindungsgemäß bewirkte Querschnittvergrößerung des Flashers im Bereich der Kavität verringern sich die maximalen Stromdichten und es ist eine höhere Anzahl von Aufheizzyklen möglich.

Gleichzeitig werden durch die erfindungsgemäße Form der Kavität die zylinderförmige Al-Pellets genau in der Längsachse der Kavität dieser Flasher positioniert, was zu einer homogeneren Ausbreitung der Al-Dampfwolke unabhängig von der Zahl der Aufheizzyklen führt.

Weiter wirkt die untere Kante dieses Querschnitts als Kapillare, was zu einer besseren Benetzung des Flashers durch das Al führt.

Sie lassen sich in üblichen Verdampferanlagen betreiben, ohne daß Veränderungen an diesen Anlagen vorgenommen werden müssen.
Fig. 1 zeigt einen Standard Flash-TV-Verdampfer in einer Einspannung in Aufsicht (A), Seitenansicht (B) und Querschnitt(C)
Fig. 2 zeigt einen erfindungsgemäßen Flasher 1 dessen Kavität 2 im Querschnitt durch den Flash-TV-Verdampfer eine Dreiecksform mit geraden Wänden 3 besitzt.
Fig. 3 zeigt einen erfindungsgemäßen Flasher 1, dessen Kavität 2 im Querschnitt durch den Flash-TV-Verdampfer eine Dreiecksform mit konvex gekrümmten Wänden 3 besitzt.

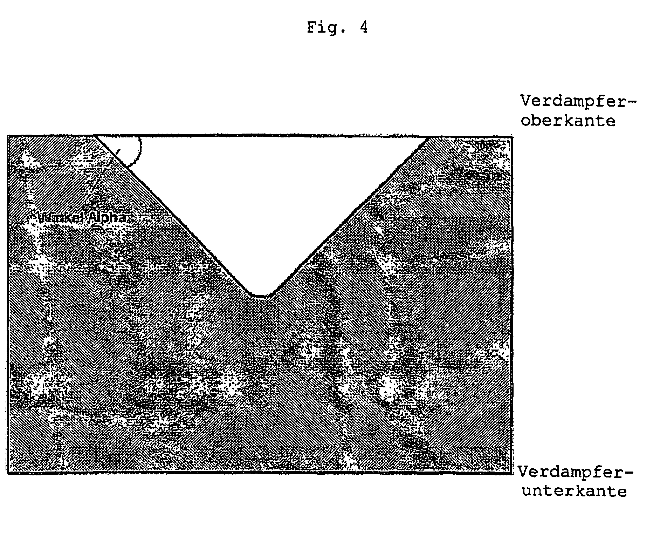

Fig. 4 zeigt einen erfindungsgemäßen Flasher 1, dessen tiefster Punkt der Kavität 2 in Form eines Radius 4 ausgeführt ist.

Das folgende Beispiel dient der weiteren Erläuterung der Erfindung:

### Beispiel:

Aus einem Sinterkörper wurde ein Flasher 1 herausgearbeitet, dessen Kavität 2 den bekannten Querschnitt (Fig. 1c) besitzt und ein Flasher, dessen Kavität den erfindungsgemäßen Querschnitt (Fig. 2) besitzt. Die beiden Flasher wurden zum Vergleich in einer Einspannung befestigt, in der zwei Flasher parallel betrieben werden können. Die zu verdampfende Aluminiummenge betrug jeweils 83 mg. Der Flasher mit bekannter Kavität hielt 820 Aufheizzyklen aus; der Flasher mit einer Kavität nach Fig. 2 hielt 1080 Aufheizzyklen aus.

Wiederholungsmessungen mit weiteren Flasherpaaren zeigten ähnliche Ergebnisse.

## Patentansprüche

1. Keramischer Flash-TV-Verdampfer, bestehend aus keramischen Pulvern, die TiB₂, BN und ggf. AlN enthalten, zum Bedampfen von Bildröhren mit Aluminium mit einer Kavität aus der das Aluminium bei Stromdurchfluß durch den Flash-TV-Verdampfer verdampft wird, **dadurch gekennzeichnet, daß** sich die Breite der Kavität von der Verdampferoberkante zur Verdampferunterkante verjüngt, wobei die Kavität im Querschnitt durch den Flash-TV-Verdampfer eine Dreiecksform mit geraden Wänden, oder mit konkav gekrümmten Wänden hat.

2. Flash-TV-Verdampfer nach Anspruch 1, **dadurch gekennzeichnet, daß** der tiefste Punkt der Kavität in Form eines Radius ausgeführt ist.

3. Flash-TV-Verdampfer nach einem der Ansprüche 1 oder 2, **dadurch gekennzeichnet, daß** die Kavität an der Verdampferoberkante 2 mm - 6 mm breit ist

4. Flash-TV-Verdampfer nach einem der Ansprüche 1 bis 3, **dadurch gekennzeichnet, daß** die tiefste Stelle der Kavität mindestens 1 mm und maximal 3 mm über der Verdampferunterkante liegt.

5. Flash-TV-Verdampfer nach einem der Ansprüche 1 bis 4, **dadurch gekennzeichnet, daß** die Länge der Kavität zwischen 30 mm und 80 mm beträgt.

## Claims

1. Ceramic flash TV evaporator consisting of ceramic powders containing TiB₂, BN and optionally AlN for the evaporation coating of cathode ray tubes with aluminium, having a cavity from which the aluminium is evaporated when a current flows through the flash TV evaporator, **characterized in that** the width of the cavity tapers from the upper edge of the evaporator to the lower edge of the evaporator, the cavity having a triangular shape with straight walls in cross section through the flash TV evaporator, or with concavely curved walls.

2. Flash TV evaporator according to Claim 1,
**characterized in that** the lowest point of the cavity is designed in the form of a radius.

3. Flash TV evaporator according to either of Claims 1 or 2, **characterized in that** the cavity is 2 mm - 6 mm wide on the upper edge of the evaporator.

4. Flash TV evaporator according to one of Claims 1 to 3, **characterized in that** the lowest location of the cavity is at least 1 mm and at most 3 mm above the lower edge of the evaporator.

5. Flash TV evaporator according to one of Claims 1 to 4, **characterized in that** the length of the cavity is between 30 mm and 80 mm.

## Revendications

1. Evaporateur TV en céramique à évaporation instantanée, constitué de poudres de céramique, qui contiennent du TiB₂, du BN et le cas échéant, de l'AlN pour le dépôt sur des tubes cathodiques, de vapeur d'aluminium au moyen d'une cavité d'où l'aluminium est vaporisé par l'évaporateur TV à évaporation instantanée lors du passage de courant, **caractérisé en ce que** la largeur de la cavité diminue du bord supérieur de la cavité au bord inférieur de la cavité, la cavité en coupe à travers l'évaporateur TV à évaporation instantanée ayant une forme triangulaire à parois droites ou à parois incurvées concaves.

2. Evaporateur TV à évaporation instantanée selon la revendication 1, **caractérisé en ce que** le point le plus bas de la cavité est réalisé en forme de rayon.

3. Evaporateur TV à évaporation instantanée selon l'une des revendications 1 ou 2, **caractérisé en ce que** la cavité a une largeur de 2 mm à 6 mm au bord supérieur d'évaporation.

4. Evaporateur TV à évaporation instantanée selon l'une des revendications 1 à 3, **caractérisé en ce que** l'endroit le plus bas de la cavité est situé au moins 1 mm et au maximum 3 mm au-dessus du bord inférieur d'évaporation.

5. Evaporateur TV à évaporation instantanée selon l'une des revendications 1 à 4, **caractérisé en ce que** la longueur de la cavité fait entre 30 mm et 80 mm.
